# EUROPEAN PATENT SPECIFICATION

(11) **EP 2 890 229 B1**
(45) Date of publication and mention of the grant of the patent: **23.09.2020**
(21) Application number: 12883260.7
(22) Date of filing: 23.08.2012
(51) Int. Cl.: H05K 13/04

(54) **COMPONENT MOUNTING DEVICE**
KOMPONENTENMONTAGEVORRICHTUNG
DISPOSITIF DE MONTAGE DE COMPOSANT

(43) Date of publication of application: 01.07.2015
(73) Proprietor: FUJI Corporation, Chiryu Aichi (JP)
(72) Inventor: NISHIYAMA, Satoru, Chiryu Aichi (JP)
(74) Representative: Grünecker Patent- und Rechtsanwälte PartG mbB
(86) International application number: PCT/JP2012/071333
(87) International publication number: WO 2014/030243

(56) References cited:
- JP-A- 2000 124 680
- JP-A- 2005 302 945
- JP-A- 2010 034 571
- JP-A- 2010 067 733
- US-A1- 2006 207 090
- US-A1- 2012 151 756

## Description

### Technical Field

The present invention relates to a component mounting device in which a plurality of nozzle holders are provided on a rotating head (rotary head) so as to be lowered at predetermined intervals in a circumferential direction of the rotating head.

### Background Art

For example, as described in PTL 1 (JP-A-2004-39818), in a rotating head type component mounting device, a plurality of nozzle holders are provided on a rotating head so as to be lowered at predetermined intervals in a circumferential direction of the rotating head, each suction nozzle is held downward below each nozzle holder, the rotating head is rotated around an R axis (vertical axis) by an R axis driving mechanism, the plurality of nozzle holders are turned in the circumferential direction of the rotating head so as to be integrated with the plurality of suction nozzles held by the plurality of nozzle holders, suction and mounting of a component are performed by lowering one nozzle holder by a Z axis driving mechanism at a predetermined position in a turning orbit, each nozzle holder is rotated around a central axis line by a Q axis driving mechanism, and a direction (angle) of each component adsorbed to each suction nozzle held by each nozzle holder is corrected.

Document JP2005302945A discloses a component mounting device comprising a head movement mechanism and a component adsorbing device comprising a exchangeable rotating head, wherein the rotating head comprises a plurality of nozzle holders, a plurality of suction nozzles, an R axis driving mechanism, a Q axis driving mechanism, a driving unit, a nozzle rotation gear mechanism and a reference gear phase indication portion. Document US2012/151756A1 discloses a component mounting device comprising a head movement mechanism and a component adsorbing device comprising an exchangeable rotating head, which in turn comprises a plurality of nozzle holders, a plurality of suction nozzles, an R axis driving mechanism and a driving unit.

### Citation List

### Patent Literature

PTL 1: JP-A-2004-39818

### Summary of Invention

### Technical Problem

In a suction nozzle held by a nozzle holder, it is necessary to use a suction nozzle having an appropriate diameter size and an appropriate pad shape according to a kind (size, shape, or the like) of a component to be adsorbed. Accordingly, the suction nozzle held by the nozzle holder is configured so as to be exchangeable according to the kind of the component to be adsorbed. However, since the rotating head cannot be exchanged, the kind (size, shape, or the like) of the suction nozzle attachable to the nozzle holder assembled to the rotating head is limited, and thus, the kind of the component which can be adsorbed is limited.

In order to solve the above-described problem, the inventor has studied a configuration in which the rotating head is attached to a head movement mechanism of a component mounting device so as to be exchangeable. However, if the entire component adsorbing device including the rotating head and a driving unit such as an R axis driving mechanism, or a Q axis driving mechanism is configured to be removed from the head movement mechanism of the component mounting device in order to be automatically exchangeable, the size of the device portion to be exchanged is increased, and thus, a cost is increased.

Accordingly, an object of the present invention is to achieve a decrease in the size of the rotating head to be exchanged, a decrease in the cost, or saving of exchange working space.

### Solution to Problem

In order to solve the above-described problems, the present invention provides technical ideas in which a rotating head can be separately attached to and detached from a driving unit and the driving unit can be used commonly with respect to all rotating heads to be exchanged. However, in this case, if the rotating head is separately removed from the driving unit, since a nozzle holder held to the rotating head can be freely rotated at an arbitrary gear phase, it is necessary to cause a gear phase of the driving unit to coincide with a gear phase of the rotating head when the rotating head is connected to the driving unit of a component adsorbing device.

The present invention is implemented as a component mounting device according to claim 1. Further embodiments are disclosed in dependent claims 2-4.

Since the rotating head can be separately attached to and detached from the driving unit of the component adsorbing device, the driving unit can be used commonly with respect to all rotating heads to be exchanged. Accordingly, it is not necessary to assemble the driving unit to the rotating head to be exchanged, and a decrease in a size and a decrease in a cost of the rotating head to be exchanged or a saving of exchange working space can be achieved. In addition, since the reference gear phase display portion is provided on the nozzle rotation gear mechanism of the rotating head, it is possible to detect a gear phase (a gear phase of the nozzle rotation gear mechanism) of the rotating head by the position of the reference gear phase display portion. Accordingly, when the rotating head is connected to the driving unit of the component adsorbing device, it is possible to cause the gear phase of the driving unit of the component adsorbing device accurately to coincide with the gear phase of the rotating head based on the position of the reference gear phase display portion.

In addition, the component mounting device may further include a rotating head disposing table on which the rotating head for exchange is disposed and a camera which is moved by the head movement mechanism, in which the reference gear phase display portion may be provided at a position at which imaging is performed by the camera from above the rotating head disposed on the rotating head disposing table, and a control device controlling an operation of the component mounting device may image the reference gear phase display portion of the rotating head disposed on the rotating head disposing table by the camera, may recognize the position of the reference gear phase display portion, may cause a gear phase of the driving unit to coincide with a gear phase of the rotating head based on the recognition result, and may connect the driving unit to the rotating head. Accordingly, irrespective of the gear phase of the rotating head disposed on the rotating head disposing table of the component mounting device, it is possible to cause the gear phase of the driving unit of the component adsorbing device automatically to coincide with the gear phase of the rotating head on the rotating head disposing table and, thus, the driving unit is connected to the rotating head.

Specifically, the nozzle rotation gear mechanism may be configured so that a cylindrical gear which is rotatably held to the rotating head and a small gear which is attached to each nozzle holder mesh with each other, the cylindrical gear is rotated by the Q axis driving mechanism of the driving unit and the small gear of each nozzle holder is rotated, and each nozzle holder is rotated, and the cylindrical gear may be configured to be rotatably held to the rotating head. Accordingly, the nozzle rotation gear mechanism which transfers the rotating force of the Q axis driving mechanism of the driving unit to each nozzle holder can be configured of one cylindrical gear and the small gear of each nozzle holder.

In addition, a Z axis driving mechanism which lowers the nozzle holder rotated to a predetermined position by rotation of the rotating head may be provided on the driving unit. Accordingly, the Z axis driving mechanism can be also used commonly with respect to all rotating heads to be exchanged.

### Brief Description of Drawings

[Fig. 1] Fig. 1 is a perspective view showing a state where a rotating head is removed from a driving unit of a component adsorbing device of an embodiment of the present invention.
[Fig. 2] Fig. 2 is a perspective view showing a state where the rotating head is connected to the driving unit of the component adsorbing device.
[Fig. 3] Fig. 3 is a perspective view of the rotating head.
[Fig. 4] Fig. 4 is a front view illustrating an operation which images a reference gear phase display portion of the rotating head by a camera and recognizes the reference gear phase display portion.
[Fig. 5] Fig. 5 is a top view illustrating the operation which images the reference gear phase display portion of the rotating head by the camera and recognizes the reference gear phase display portion.
[Fig. 6] Fig. 6 is a block diagram showing a configuration of a control system of the component mounting device.

### Description of Embodiments

Hereinafter, an embodiment exemplifying an aspect of the present invention will be described. First, a configuration of a component adsorbing device 10 of a component mounting device will be described.

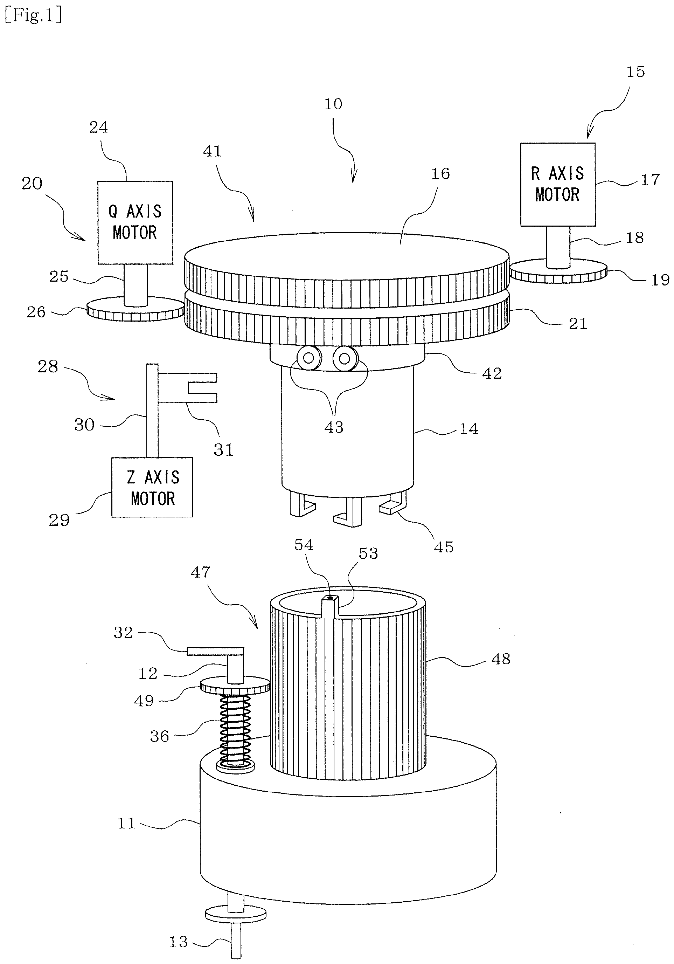

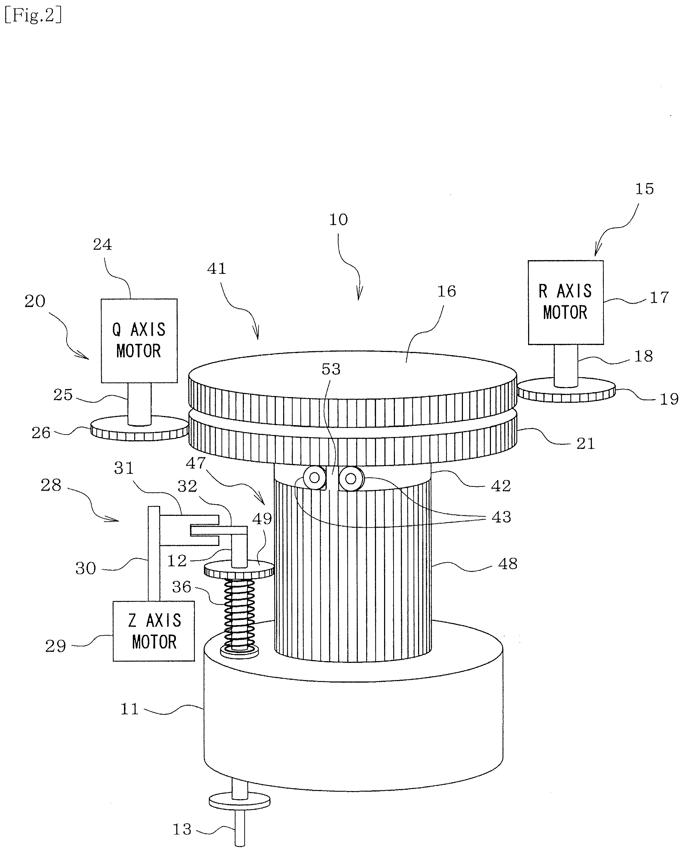

In a rotating head 11 of the component adsorbing device 10, a plurality of nozzle holders 12 are held so as to be lowered at predetermined intervals in a circumferential direction of the rotating head, and a suction nozzle 13 adsorbing each component is held downward below each nozzle holder 12. Each nozzle holder 12 is biased upward by each spring 36. In addition, in Figs. 1 and 2, only one nozzle holder 12 is shown, and other nozzle holders 12 are not shown.

The rotating head 11 is connected to an R axis 14 extending to the lower portion of a driving unit 41 so as to be exchangeable (detachable), and an R axis gear 16 of an R axis driving mechanism 15 is concentrically fixed to an upper end of the R axis 14. A gear 19 fixed to a rotating axis 18 of an R axis motor 17 meshes with the R axis gear 16, the R axis gear 16 is rotated by the rotation of the gear 19 of the R axis motor 17, the rotating head 11 is rotated about the R axis 14, and thus, the plurality of nozzle holders 12 are turned in the circumferential direction of the rotating head 11 so as to be integrated with the plurality of suction nozzles 13.

A Q axis gear 21 of a Q axis driving mechanism 20 is rotatably inserted into the R axis 14, a gear 26 fixed to a rotating axis 25 of a Q axis motor 24 meshes with the Q axis gear 21, and the Q axis gear 21 is rotated around the R axis 14 by the rotation of the gear 26 of the Q axis motor 24. A ring-shaped flange portion 42 is provided on the lower surface of the Q axis gear 21 to protrude downward, and a pair of positioning rollers 43 for allowing a gear phase of the rotating head 11 to coincide with a phase of the Q axis gear 21 of the driving unit 41 is provided on the outer circumferential surface of the flange portion 42 at predetermined intervals. Accordingly, the pair of positioning rollers 43 is rotated around the R axis 14 so as to be integrated with the Q axis gear 21.

The R axis 14 functions as a head holding portion which detachably holds the rotating head 11, a plurality of (for example, four) engagement members 45 for detachably engaging and holding the rotating head 11 are provided to vertically move on the lower end portion of the R axis 14, and an air cylinder (not shown) driving each engagement member 45 vertically is provided in the vicinity of each engagement member 45. Each engagement member 45 is formed in a L shape or a J shape, the engagement members 45 are arranged at equal intervals in the circumferential direction of the R axis 14, and hook portions of engagement members 45 are aligned to have the same direction as a forward direction (or a reverse direction) of the R axis 14.

Meanwhile, a nozzle rotation gear mechanism 47 which transfers a rotating force of the Q axis gear 21 to each nozzle holder 12 is provided on the rotating head 11. In the nozzle rotation gear mechanism 47, a cylindrical gear 48 which is rotatably held concentrically on the upper portion side of the rotating head 11, and a small gear 49 which is attached to each nozzle holder 12 mesh with each other, the cylindrical gear 48 is rotated by the Q axis gear 21 of the driving unit 41 and the small gear 49 of each nozzle holder 12 is rotated, the nozzle holder 12 is rotated around the central axis line of each nozzle holder 12, and thus, a direction (angle) of each component adsorbed to each suction nozzle 13 held by each nozzle holder 12 is corrected.

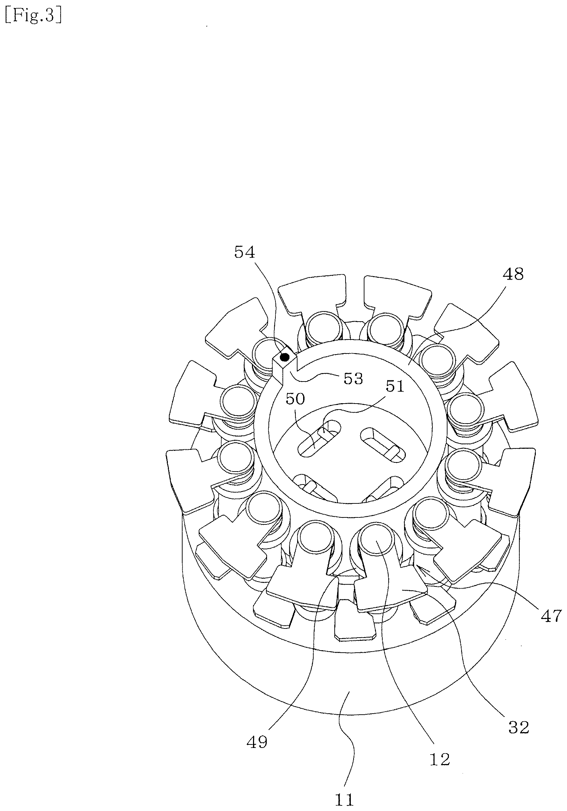

The cylindrical gear 48 is formed to allow the R axis 14 to be inserted therein. As shown in Fig. 3, at a position inside the cylindrical gear 48 which is the portion on the upper surface portion of the rotating head 11, a plurality of long holes 50 into which the engagement members 45 of the R axis 14 are inserted are formed at equal intervals in the circumferential direction, and an engaged pin 51 (engaged member) with which the hook portion of the engagement member 45 engages penetrates thereinto and is fixed in a radial direction of the rotating head 11 on one side of each long hole 50. A space through which the engagement member 45 slips vertically is secured on the side of the engaged pin 51 inside each long hole 50.

When the rotating head 11 is connected to the driving unit 41, the R axis 14 is inserted into the cylindrical gear 48 and each engagement member 45 of the R axis 14 is inserted into each long hole 50 of the rotating head 11, the R axis 14 is rotated by the rotation of the R axis gear 16, and the engagement member 45 is lifted up and held in a state where each engagement member 45 engages with the engaged pin 51 inside each long hole 50.

A positioning protrusion 53 is formed to protrude upward at a predetermined position on the upper end portion of the cylindrical gear 48, and a reference mark 54 (reference gear phase display portion) displaying a gear phase which becomes a reference for the cylindrical gear 48 is formed on the upper surface of the positioning protrusion 53. When the rotating head 11 is connected to the driving unit 41, as shown in Fig. 2, the positioning protrusion 53 is interposed between the pair of positioning rollers 43 of the Q axis gear 21, the rotation of the cylindrical gear 48 is stopped with respect to the Q axis gear 21, and thus, the Q axis gear 21 and the cylindrical gear 48 are integrally rotated.

In addition to the R axis driving mechanism 15 and the Q axis driving mechanism 20, a Z axis driving mechanism 28 is assembled to the driving unit 41, and the nozzle holder 12 is lowered to a predetermined stop position of a turning orbit of the nozzle holder 12 by the Z axis driving mechanism 28. In the Z axis driving mechanism 28, a Z axis motor 29 is used as an actuator, a feed screw 30 is rotated by the Z axis motor 29 and a Z axis slide 31 is moved vertically, the Z axis slide 31 engages with an engagement piece 32 provided on the upper end of the nozzle holder 12, and thus, the nozzle holder 12 is moved vertically. Moreover, a linear motor may be used as the Z axis motor 29 to move the Z axis slide 31 vertically. Alternatively, instead of the linear motor, a linear solenoid, an air cylinder, or the like may be used. One Z axis driving mechanism 28 may be provided, and a plurality of Z axis driving mechanisms may be provided at predetermined intervals in the circumferential direction of the rotating head 11.

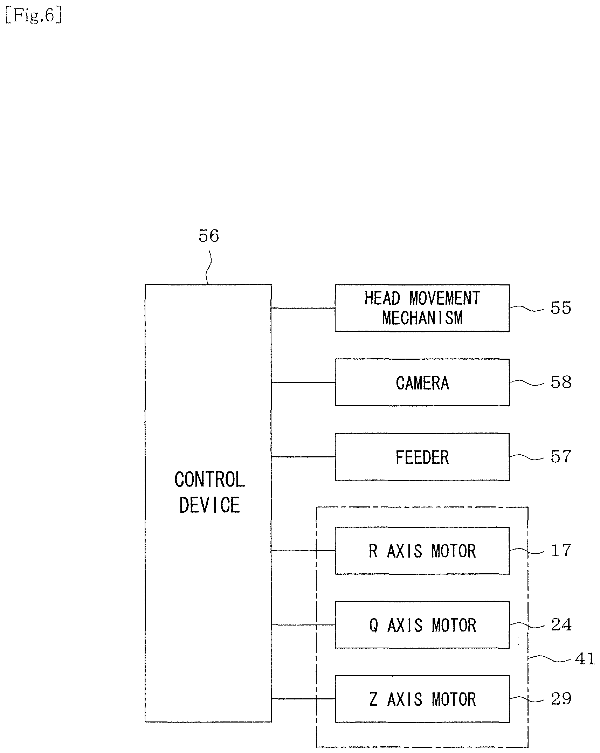

The driving unit 41 of the component adsorbing device 10 described as above is supported by a head movement mechanism 55 (refer to Fig. 6) of the component mounting device and moves in XYZ directions. A control device 56 (control means) of the component mounting device controls the head movement mechanism 55, and the R axis motor 17, the Q axis motor 24, and the Z axis motor 29 of the driving unit 41 according to a production program, and controls an operation which adsorbs a component supplied from a plurality of feeders 57 to the suction nozzle 13 and mounts the component on a circuit substrate.

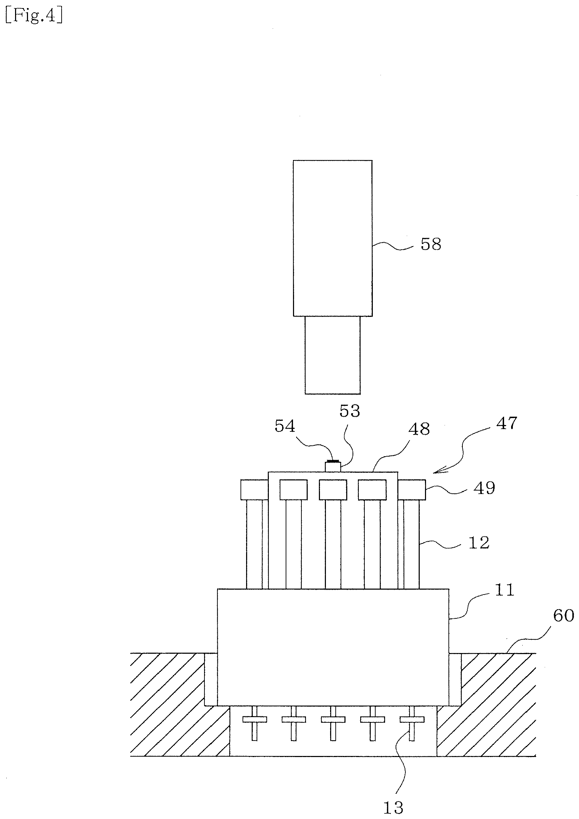

A camera 58 which images a reference mark of the circuit substrate is mounted on the component mounting device, and the camera 58 is integrally moved with the component adsorbing device 10 by the head movement mechanism 55. In addition, a rotating head disposing table 60 (refer to Fig. 4) on which the rotating head 11 removed from the driving unit 41 is disposed is provided on the component mounting device. The plurality of rotating heads 11 for exchange can be disposed on the rotating head disposing table 60. The camera 58 is also used as a camera which images the reference mark 54 of the rotating head 11 on the rotating head disposing table 60 in addition to the reference mark of the circuit substrate.

Next, a method which connects the rotating head 11 disposed on the rotating head disposing table 60 to the driving unit 41 of the component adsorbing device 10 will be described.

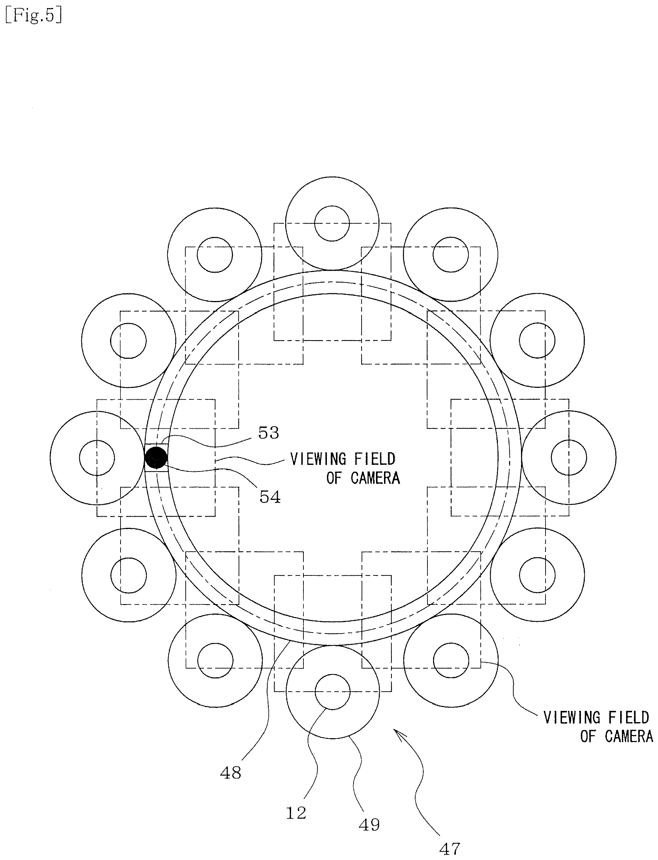

First, as shown in Fig. 4, the camera 58 is moved above the rotating head 11 disposed on the rotating head disposing table 60, the upper end portion of the cylindrical gear 48 is imaged by the camera 58, and presence or absence of the reference mark 54 is determined by image processing. When it is determined that the reference mark 54 is absent, by repeating processing which images the reference mark by slightly moving the position (imaging area) of the camera 58 in the circumferential direction of the cylindrical gear 48 and determines the presence or the absence of the reference mark 54 by image processing, the reference mark 54 may be found (refer to Fig. 5). Accordingly, the position of the reference mark 54 (positioning protrusion 53) is detected, and the phase of the cylindrical gear 48 is detected.

Thereafter, the R axis 14 of the driving unit 41 is moved above the rotating head 11 by the head movement mechanism 55, and the phase of the Q axis gear 21 of the driving unit 41 is coincident with the phase of the cylindrical gear 48 of the rotating head 11 by the Q axis motor 24. Thereafter, the driving unit 41 is lowered by the head movement mechanism 55, the R axis 14 is inserted into the cylindrical gear 48, and the positioning protrusion 53 of the cylindrical gear 48 is interposed between the pair of positioning rollers 43 of the Q axis gear 21. At this time, each engagement member 45 of the R axis 14 is inserted into each long hole 50 of the rotating head 11, the R axis 14 is rotated by rotating the R axis gear 16 by the R axis motor 17 and each engagement member 45 engages with the engaged pin 51 inside each long hole 50, and thereafter, each engagement member 45 is lifted up by an air cylinder (not shown), and the engagement state is held. Accordingly, the operation which connects the rotating head 11 to the driving unit 41 is completed.

According to the present embodiment described above, since the rotating head 11 can be separately attached to and detached from the driving unit 41 of the component adsorbing device 10, the driving unit 41 can be used commonly with respect to all rotating heads 11 to be exchanged. Accordingly, it is not necessary to assemble the driving unit 41 to the rotating head 11 to be exchanged, and a decrease in a size and a decrease in a cost of the rotating head 11 to be exchanged or a saving in exchange working space can be achieved. In addition, since the reference mark 54 (positioning protrusion 53) displaying the reference gear phase is provided on the cylindrical gear 48 of the nozzle rotation gear mechanism 47 of the rotating head 11, it is possible to detect the gear phase (the gear phase of the nozzle rotation gear mechanism 47) of the rotating head 11 by the position of the reference mark 54 (positioning protrusion 53). Accordingly, when the rotating head 11 is connected to the driving unit 41 of the component adsorbing device 10, it is possible to cause the gear phase (the phase of the Q axis gear 21) of the driving unit 41 of the component adsorbing device 10 accurately to coincide with the gear phase of the rotating head 11 based on the position of the reference mark 54 (positioning protrusion 53).

In addition, in the present embodiment, the reference mark 54 of the rotating head 11 disposed on the rotating head disposing table 60 is imaged by the camera 58 from above to recognize the position of the reference mark 54, the gear phase of the driving unit 41 and the gear phase of the rotating head 11 are coincident with each other based on the recognition result, the driving unit 41 is connected to the rotating head 11, and thus, irrespective of the gear phase of the rotating head 11 disposed on the rotating head disposing table 60 of the component mounting device, it is possible to cause the gear phase of the driving unit 41 of the component adsorbing device 10 automatically to coincide with the gear phase of the rotating head 11 on the rotating head disposing table 60 and thus, the driving unit is connected to the rotating head. Accordingly, when the rotating head 11 is disposed on the rotating head disposing table 60, it is not necessary to cause the gear phase of the rotating head 11 to coincide with a specific phase, the structure of the rotating head disposing table 60 is simplified, and thus, it is possible to decrease the number of parts or a cost of the rotating head disposing table 60.

In addition, the present invention is not limited to the embodiment, and for example, a configuration in which the rotating head 11 is engaged with and held to the driving unit 41 may be appropriately modified, or the like, and various modifications may be performed within the scope of the claims.

### Reference Number List

10: component adsorbing device, 11: rotating head, 12: nozzle holder, 13: suction nozzle, 14: R axis, 15: R axis driving mechanism, 16: R axis gear, 17: R axis motor, 20: Q axis driving mechanism, 21: Q axis gear, 24: Q axis motor, 28: Z axis driving mechanism, 29: Z axis motor, 30: feed screw, 31: Z axis slide, 32: engagement piece, 41: driving unit, 43: positioning roller, 45: engagement member, 47: nozzle rotation gear mechanism, 48: cylindrical gear, 49: small gear, 50: long hole, 51: engaged pin, 53: positioning protrusion, 54: reference mark (reference gear phase display portion), 55: head movement mechanism, 56: control device, 58: camera, 60: rotating head disposing table

## Claims

1. A component mounting device comprising:
a head movement mechanism (55), and
a component adsorbing device (10) which is configured to be moved by the head movement mechanism (55),
wherein the component adsorbing device (10) includes:
a rotating head (11) which is provided to be concentrically rotatable around an R axis (14) extending vertically;
a plurality of nozzle holders (12) which are held lowerable to the rotating head (11) at predetermined intervals in a circumferential direction of the rotating head (11);
a plurality of suction nozzles (13), wherein each suction nozzle (13) is held downward below a corresponding one of the plurality of nozzle holders (12), and is configured to adsorb a component;
an R axis driving mechanism (15) which is configured to rotate the plurality of nozzle holders (12) in the circumferential direction of the rotating head (11) integrally with the plurality of suction nozzles (13) by rotating the rotating head (11) around the R axis (14);
a Q axis driving mechanism (20) which is configured to correct a direction of each component adsorbed to each suction nozzle (13) held by each nozzle holder (12) by rotating each of the plurality of nozzle holders (12) around a vertical central axis line Q, of each nozzle holder (12);
a driving unit (41) which comprises the R axis driving mechanism (15) and the Q axis driving mechanism (20), and is configured to be attached to the head movement mechanism (55), wherein the rotating head (11) to which the plurality of nozzle holders (12) are held is configured to be detachably connected to the driving unit (41),
a nozzle rotation gear mechanism (47) which is configured to transfer a rotating force of the Q axis driving mechanism (20) to each nozzle holder (12), and is provided on the rotating head (11); and
a reference gear phase indicating portion (54) which is configured to indicate a gear phase which becomes a reference for the nozzle rotation gear mechanism (47), and is provided on the nozzle rotation gear mechanism (47).

2. The component mounting device according to claim 1, further comprising:
a rotating head disposing table (60) on which the rotating head (11) for exchange can be disposed; and
a camera (58) which is configured to be moved by the head movement mechanism (55), wherein the reference gear phase indicating portion (54) is provided at a position at which imaging is performed by the camera (58) from above the rotating head (11) disposed on the rotating head disposing table (60), and
wherein a control device (56) for controlling an operation of the component mounting device is configured to image the reference gear phase indicating portion (54) of the rotating head (11) disposed on the rotating head disposing table (60) by the camera (58), to recognize the position of the reference gear phase indicating portion (54), to cause a gear phase of the driving unit (41) to coincide with a gear phase of the rotating head (11) based on the recognition result, and to connect the driving unit (41) to the rotating head (11).

3. The component mounting device according to claim 1 or 2,
wherein the nozzle rotation gear mechanism (47) is configured so that a cylindrical gear (48) which is rotatably held to the rotating head (11) and a gear (49) which is attached to each nozzle holder (12) mesh with each other, the cylindrical gear (48) can be rotated by the Q axis driving mechanism (20) of the driving unit (41) and the gear (49) of each nozzle holder (12) can be rotated, and each nozzle holder (12) can be rotated.

4. The component mounting device according to any one of claims 1 to 3,
wherein a Z axis driving mechanism (28) which is configured to lower the nozzle holder (12) rotated to a predetermined position by rotation of the rotating head (11) is provided on the driving unit (41).

## Patentansprüche

1. Vorrichtung zum Montieren von Bauteilen, die umfasst:
einen Kopf-Bewegungsmechanismus (55), sowie
eine Bauteil-Ansaugvorrichtung (10), die so ausgeführt ist, dass sie durch den Kopf-Bewegungsmechanismus (55) bewegt wird,
wobei die Bauteil-Ansaugvorrichtung (10) enthält:
einen Drehkopf (11), der so eingerichtet ist, dass er konzentrisch um eine sich vertikal erstreckende R-Achse (14) herum gedreht werden kann;
eine Vielzahl von Düsenhaltern (12), die in vorgegebenen Intervallen in einer Umfangsrichtung des Drehkopfes (11) absenkbar an dem Drehkopf (11) gehalten werden;
eine Vielzahl von Saugdüsen (13), wobei jede Saugdüse (13) unterhalb eines entsprechenden der Vielzahl von Düsenhaltern (12) nach unten gerichtet gehalten wird und so ausgeführt ist, dass sie ein Bauteil ansaugt;
einen R-Achsen-Antriebsmechanismus (15), der so ausgeführt ist, dass er die Vielzahl von Düsenhaltern (12) in der Umfangsrichtung des Drehkopfes (11) integral mit der Vielzahl von Saugdüsen (13) dreht, indem er den Drehkopf (11) um die R-Achse (14) herum dreht;
einen Q-Achsen-Antriebsmechanismus (20), der so ausgeführt ist, dass er eine Richtung jedes Bauteils, das an jede von jedem Düsenhalter (12) gehaltene Saugdüse (13) angesaugt wird, korrigiert, indem er jeden der Vielzahl von Düsenhaltern (12) um eine vertikale Mittelachsenlinie Q jedes Düsenhalters (12) herum dreht;
eine Antriebs-Einheit (41), die den R-Achsen-Antriebsmechanismus (15) und den Q-Achsen-Antriebsmechanismus (20) umfasst und so ausgeführt ist, dass sie an dem Kopf-Bewegungsmechanismus (55) angebracht ist,
wobei der Drehkopf (11), an dem die Vielzahl von Düsenhaltern (12) gehalten wird, so ausgeführt ist, dass er lösbar mit der Antriebs-Einheit (41) verbunden ist,
einen Düsendrehungs-Zahnradmechanismus (47), der so ausgeführt ist, dass er eine Drehkraft des Q-Achsen-Antriebsmechanismus (20) auf jeden Düsenhalter (12) überträgt, und der an dem Drehkopf (11) vorhanden ist; sowie
einen Abschnitt (54) zum Anzeigen einer Bezugs-Zahnradphase, der so ausgeführt ist, dass er eine Zahnradphase anzeigt, die zu einer Bezugsgröße für den Düsendrehungs-Zahnradmechanismus (47) wird, und der an dem Düsendrehungs-Zahnradmechanismus (47) vorhanden ist.

2. Vorrichtung zum Montieren von Bauteilen nach Anspruch 1, des Weiteren umfassend:
einen Drehkopf-Ablagetisch (60), auf dem der Drehkopf (11) zum Austausch abgelegt werden kann; sowie
eine Kamera (58), die so ausgeführt ist, dass sie durch den Kopf-Bewegungsmechanismus (55) bewegt wird,
wobei sich der Abschnitt (54) zum Anzeigen einer Bezugs-Zahnradphase an einer Position befindet, an der Bilderzeugung durch die Kamera (58) von oberhalb des auf dem Drehkopf-Ablagetisch (60) abgelegten Drehkopfes (11) durchgeführt wird, und
wobei eine Steuerungsvorrichtung (56) zum Steuern einer Funktion der Vorrichtung zum Montieren von Bauteilen so ausgeführt ist, dass sie ein Bild des Abschnitts (54) zum Anzeigen einer Bezugs-Zahnradphase des auf dem Drehkopf-Ablagetisch (60) abgelegten Drehkopfes (11) mit der Kamera (58) erzeugt, die Position des Abschnitts (54) zum Anzeigen einer Bezugs-Zahnradphase erkennt, auf Basis des Erkennungsergebnisses veranlasst, dass eine Zahnradphase der Antriebs-Einheit (41) mit einer Zahnradphase des Drehkopfes (11) übereinstimmt, und die Antriebs-Einheit (41) mit dem Drehkopf (11) verbindet.

3. Vorrichtung zum Montieren von Bauteilen nach Anspruch 1 oder 2,
wobei der Düsendrehungs-Zahnradmechanismus (47) so ausgeführt ist, dass ein zylindrisches Zahnrad (48), das drehbar an dem Drehkopf (11) gehalten wird, und ein Zahnrad (49), das an jedem Düsenhalter (12) angebracht ist, miteinander kämmen, wobei das zylindrische Zahnrad (48) durch den Q-Achsen-Antriebsmechanismus (20) der Antriebs-Einheit (41) gedreht werden kann und das Zahnrad (49) jedes Düsenhalters (12) gedreht werden kann, und jeder Düsenhalter (12) gedreht werden kann.

4. Vorrichtung zum Montieren von Bauteilen nach einem der Ansprüche 1 bis 3,
wobei ein Z-Achsen-Antriebsmechanismus (28), der so ausgeführt ist, dass er den durch Drehung des Drehkopfes (11) an eine vorgegebene Position gedrehten Düsenhalter (12) absenkt, an der Antriebs-Einheit (41) vorhanden ist.

## Revendications

1. Dispositif de montage de composants comprenant :
un mécanisme de mouvement de tête (55), et
un dispositif d'absorption de composant (10) qui est configuré pour être déplacé par le mécanisme de mouvement de tête (55),
dans lequel le dispositif d'absorption de composant (10) inclut :
une tête rotative (11) qui est disposée pour être mobile en rotation concentrique autour d'un axe R (14) s'étendant verticalement ;
une pluralité de supports de buse (12) qui sont maintenus abaissables vers la tête rotative (11) à des intervalles prédéterminés dans une direction circonférentielle de la tête rotative (11) ;
une pluralité de buses aspirantes (13), dans lequel chaque buse aspirante (13) est maintenue vers le bas sous un correspondant de la pluralité de supports de buse (12), et est configurée pour absorber un composant ;
un mécanisme d'entraînement d'axe R (15) qui est configuré pour faire tourner la pluralité de supports de buses (12) dans la direction circonférentielle de la tête rotative (11) intégralement avec la pluralité de buses aspirantes (13) en faisant tourner la tête rotative (11) autour de l'axe R (14) ;
un mécanisme d'entraînement d'axe Q (20) qui est configuré pour corriger une direction de chaque composant absorbé vers chaque buse aspirante (13) maintenue par chaque support de buse (12) en faisant tourner chacun de la pluralité de supports de buse (12) autour d'une ligne axiale centrale verticale Q, de chaque support de buse (12) ;
une unité d'entraînement (41) qui comprend le mécanisme d'entraînement d'axe R (15) et le mécanisme d'entraînement d'axe Q (20), et est configurée pour être rattachée au mécanisme de mouvement de tête (55), dans lequel la tête rotative (11) sur laquelle la pluralité de supports de buse (12) sont maintenus est configurée pour être connectée de manière amovible à l'unité d'entraînement (41),
un mécanisme d'engrenage de rotation de buse (47) qui est configuré pour transférer une force de rotation du mécanisme d'entraînement d'axe Q (20) à chaque support de buse (12), et est disposé sur la tête rotative (11) ; et
une partie d'indication de phase d'engrenage de référence (54) qui est configurée pour indiquer une phase d'engrenage qui devient une référence pour le mécanisme d'engrenage de rotation de buse (47), et est installée sur le mécanisme d'engrenage de rotation de buse (47).

2. Le dispositif de montage de composants selon la revendication 1, comprenant en outre :
une table de disposition de tête rotative (60) sur laquelle la tête rotative (11) à échanger peut être disposée ; et
une caméra (58) qui est configurée pour être déplacée par le mécanisme de mouvement de tête (55), dans lequel la partie d'indication de phase d'engrenage de référence (54) est disposée à un emplacement auquel une imagerie est exécutée par la caméra (58) depuis le dessus de la tête rotative (11) disposée sur la table de disposition de tête rotative (60), et
dans lequel un dispositif de contrôle (56) pour contrôler une opération du dispositif de montage de composants est configuré pour effectuer une imagerie de la partie d'indication de phase d'engrenage de référence (54) de la tête rotative (11) disposée sur la table de disposition de tête rotative (60) par la caméra (58), pour identifier la position de la partie d'indication de phase d'engrenage de référence (54), pour induire une phase d'engrenage de l'unité d'entraînement (41) pour coïncider avec une phase d'engrenage de la tête rotative (11) selon le résultat d'identification, et pour connecter l'unité d'entraînement (41) à la tête rotative (11) .

3. Le dispositif de montage de composants selon la revendication 1 ou 2,
dans lequel le mécanisme d'entraînement de rotation de buse (47) est configuré de sorte qu'un pignon cylindrique (48) qui est maintenu en rotation sur la tête rotative (11) et un pignon (49) qui est rattaché à chaque support de buse (12) se solidarisent l'un avec l'autre, le pignon cylindrique (48) peut être tourné par le mécanisme d'entraînement d'axe Q (20) de l'unité d'entraînement (41) et le pignon (49) de chaque support de buse (12) peut être tourné, et chaque support de buse (12) peut être tourné.

4. Le dispositif de montage de composants selon l'une quelconque des revendications 1 à 3,
dans lequel un mécanisme d'entraînement d'axe Z (28) qui est configuré pour abaisser le support de buse (12) tourné vers une position prédéterminée par une rotation de la tête rotative (11) est disposé sur l'unité d'entraînement (41).
